# EUROPÄISCHE PATENTSCHRIFT

(11) **EP 0 580 837 B1**
(45) Veröffentlichungstag und Bekanntmachung des Hinweises auf die Patenterteilung: **07.01.1998**
(21) Anmeldenummer: 93903170.4
(22) Anmeldetag: 13.02.1993
(51) Int. Cl.: C23C 14/54, C23C 14/34, C23C 14/00

(54) **VERFAHREN ZUR HERSTELLUNG DÜNNER SCHICHTEN MITTELS REAKTIVER KATHODENZERSTÄUBUNG UND VORRICHTUNG ZUR DURCHFÜHRUNG DES VERFAHRENS**
PROCESS FOR PRODUCING THIN FILMS BY MEANS OF REACTIVE CATHODE SPUTTERING AND DEVICE FOR IMPLEMENTING IT
PROCEDE ET DISPOSITIF POUR L'OBTENTION DE COUCHES MINCES PAR PULVERISATION CATHODIQUE REACTIVE

(30) Priorität: 14.02.1992 DE 4204371; 22.08.1992 DE 4227961
(43) Veröffentlichungstag der Anmeldung: 02.02.1994
(60) Teilanmeldung: 96113800.5
(73) Patentinhaber: FORSCHUNGSZENTRUM JÜLICH GMBH, 52425 Jülich (DE)
(72) Erfinder: WÖRDENWEBER, Roger, D-5162 Niederzier (DE); KRÜGER, Ursus, D-5000 Köln 1 (DE); KUTZNER, Rolf, D-5170 Jülich (DE)
(86) Internationale Anmeldenummer: DE9300125
(87) Internationale Veröffentlichungsnummer: WO9316211

(56) Entgegenhaltungen:
- EP-A- 0 282 835
- DE-A- 3 730 834
- FR-A- 2 503 190

## Beschreibung

Die Erfindung betrifft ein Verfahren zur Herstellung dünner Schichten mittels reaktiver Kathodenzerstäubung gemäß dem Oberbegriff des Anspruchs 1. Die Erfindung betrifft ferner eine Vorrichtung zur Herstellung dünner Schichten gemäß dem Oberbegriff des Anspruchs 8.

Nach der Entdeckung der oxydischen Hochtemperatursupraleiter im Jahre 1986 ist man bestrebt, diesen Werkstoff in der Mikroelektronik einzusetzen. Es handelt sich bei den oxydischen Hochtemperatursupraleitern um Materialien mit einer komplizierten Struktur. Damit möglichst gute, nach Möglichkeit epitaktisch aufgewachsene Schichten hergestellt werden können, ist es erforderlich, bei der Dünnschichtherstellung dieser oxydischen Hochtemperatursupraleiter einen optimierten und während der Deposition zeitlich möglichst stabilen Ablauf der Abscheidung zu gewährleisten.

Eine Möglichkeit der Dünnschichtherstellung solcher Materialien liegt in dem Verfahren der Kathodenzerstäubung. Dabei kann man mit entsprechend technischem Aufwand zwar die meisten Depositionsparameter, wie z.B. Substrat- oder Targettemperatur, Sputterleistung, Sputterstrom oder Prozeßgasdruck konstant halten.

Bei den bisher bekannten Kathodenzerstäubungsverfahren zeigt sich jedoch nachteilig, daß die abgeschiedenen Filme aus oxydischen Hochtemperatursupraleitern nicht perfekt einkristallin aufwachsen, sondern Inhomogenitäten in der Filmstruktur aufweisen.

Es ist daher Aufgabe der vorliegenden Erfindung, ein Verfahren der eingangs genannten Art zu schaffen, das die genannten Nachteile vermindert und im Ergebnis zu einem Dünnfilm, insbesondere aus einem oxydischen Hochtemperatursupraleiter, mit verminderter Inhomogenität führt. Es ist weiterhin Aufgabe der Erfindung, eine Vorrichtung zur Herstellung solcher Dünnschichten zu schaffen.

Die erfindungsgemäße Aufgabe wird durch ein Verfahren gelöst, bei dem das Prozeßgas in der Kammer bis an das Plasma herangeführt wird, das des Target während der Kathodenzerstäubung umgibt. In einem räumlichen Bereich einer zur Targetoberfläche parallel verlaufenden Querschnittsfläche im Plasma wird dabei spektroskopisch wenigstens eine Emissionslinie für die Dauer der Kathodenzerstäubung in-situ profilmäßig erfaßt. Nach Einstellen eines gewünschten Querschnittprofiles beim Einsputtervorgang wird dieses Querschnittsprofil zeitlich konstant gehalten, indem das Prozeßgasmischungsverhältnis nachgeregelt wird.

An dieser Stelle sei erwähnt, daß zeitliche Veränderungen des Plasmas zum einen daher rühren, daß jedes sich in der Nähe des Plasmas befindliche Potential zu Veränderungen im elektrischen Feld und damit zu Veränderungen im Plasma führt. Die zeitlichen Schwankungen der Plasmaeigenschaften können durch Potentialänderungen beispielsweise durch Aufladung durch Ladungsübertrag von Ionen aus dem Plasma auf die Oberflächen hervorgerufen werden.

Die zeitliche Änderung im Plasma kann andererseits durch die Beteiligung von Sauerstoff bei der Deposition von Hochtemperatursupraleitern hervorgerufen werden. Der Sauerstoff wird in die aus oxydischem hochtemperatursupraleitendem Material bestehenden Schicht eingebaut (z.B. YBa₂Cu₃O₇) und ist deswegen auch im Prozeßgas vorhanden. Der Sauerstoff kann dabei auf die Oberflächen, insbesondere auch die Targetoberfläche, angelagert oder wieder von ihnen freigegeben werden. Infolgedessen wird dem Abscheidungsprozeß Sauerstoff entzogen bzw. zugeführt. Es wurde erkannt, daß vor allem der Sauerstoffgehalt der Targetoberfläche bei diesen zeitlichen Änderungen im Plasma eine wesentliche Rolle spieltn. Je nach Sauerstoffgehalt zeigen einige Hochtemperatursupraleiter (HTSL) metallisches oder Isolatorverhalten.

Das erfindungsgemäße Verfahren ist nicht auf die Herstellung dünner Schichten aus hochtemperatursupraleitenden Materialien beschränkt. Vielmehr ist das erfindungsgemäße Verfahren überall dort einsetzbar, wo mit Hilfe der reaktiven Kthodenzerstäubung dünne Schichten hergestellt werden.

Es wurde erkannt, daß die zeitlichen Änderungen des Plasmas sich aus zwei unterschiedlichen Komponenten zusammensetzen. Zum einen zeigt ein solches Targetplasma periodische Schwankungen im Bereich von einigen Minuten. Dazu wurde eine ausgewählte Emissionslinie einer Komponente des Plasmas emissionsspektroskopisch erfaßt und profilmäßig dargestellt. Zum anderen weist das Targetplasma Kurzzeitschwankungen im Bereich von Bruchteilen von Sekunden bis zu einigen Sekunden auf. Diese Schwankungen zeigen sich z.B. in der gemessenen integralen Intensität des emissionsspektroskopisch erfaßten Querschnittsprofils des Plasmas.

Gemäß dem erfindungsgemäßen Verfahren wird während der Kathodenzerstäubung das Querschnittsprofil emissionsspektroskopisch erfaßt, ein gewünschtes Querschnittsprofil eingestellt. Im zeitlichen Verlauf wird dieses Querschnittsprofil konstant gehalten, indem das Prozeßgasmischungsverhältnis nachgeregelt wird. In vorteilhafter Weise wird mit Hilfe des erfindungsgemäßen Verfahrens erreicht, daß infolge der Konstanz des Querschnittprofils auch die kurzzeitigen Schwankungen in der integralen Intensität des Emissionssignals stark reduziert werden. Im Ergebnis liefert das erfindungsgemäße Verfahren damit auch eine kontrolliertere Deposition des HTSL-Materials auf das Substrat und damit eine Verbesserung der Qualität solcher mit Hilfe der Kathodenzerstäubung hergestellten Dünnfilme.

Das erfindungsgemäße Verfahren erfaßt vorteilhafterweise sowohl eine Optimierung als auch eine verbesserte Steuerung des Depositionsprozesses. Zur Optimierung des Prozeßgasmischungsverhältnisses wird das Prozeßgas gezielt an das Plasma herangeführt, bevorzugt in der Nähe der Targetoberfläche. Eine weitere Möglichkeit der Optimierung des Depositionsprozesses kann darin liegen, die Position des Substrates und/oder das Nachfahren der Substratposition zu beeinflussen in Abhängigkeit der emissionsspektroskopisch beobachteten Schwankung in der Linienintensität. Dabei ist das erfindungsgemäße Verfahren keineswegs nur auf die Beschichtung kleiner Substrate, sondern in vorteilhafter Weise gerade auch bei großflächiger Beschichtung von Vorteil. Weiterhin könnten geeignete Profilblenden gezielt in das Targetplasma eingebracht werden.

Zur Verbesserung der HTSL-Schichtherstellung mit Hilfe der Kathodenzerstäubung erlaubt das erfindungsgemäße Verfahren eine Prozeßstabilisierung durch Konstanthaltung des beobachteten Profils des Emissionssignals. Dies kann durch zusätzliches und/oder vermindertes Anbieten des Prozeßgases geschehen.

Im Falle der Herstellung dünner Filme aus oxydischen, hochtemperatursupraleitenden Materialien mit Hilfe reaktiver Kathodenzerstäubung unter Verwendung von einem Sauerstoff/Argon-Gasgemisch ist es möglich, im Sinne des erfindungsgemäßen Verfahrens die Emissionslinie von 845 nm des atomaren Sauerstoffs zu beobachten und über das erhaltene Signal nachzusteuern. Es kann jedoch auch eine andere Emissionslinie des Sauerstoffs gewählt werden. Darüber hinaus ist auch die Möglichkeit gegeben, eine oder mehrere Emissionslinien der Inertgaskomponente Argon im Gasgemisch zu wählen. Schließlich könnte auch eine Emissionslinie einer anderen im Targetplasma vorhandenen Komponente gewählt werden.

Eine gleichmäßige Deposition kann mit Hilfe der vorteilhaften Variante gemäß Anspruch 2 erzielt werden. Bei der Einstellung des Querschnittprofiles in einer zur Targetoberfläche parallel verlaufenden Querschnittsfläche - senkrecht zur Symmetrieachse des Targets bei symmetrischen Targets - im Plasma wird dazu ein symmetrisches Profil, möglichst mit einem über die ganze Querschnittsfläche gleichen Intensitätswert eingestellt.

Weitere zweckmäßige oder vorteilhafte Varianten des erfindungsgemäßen Verfahrens finden sich in den Ansprüchen 3 bis 7.

Es wurde insbesondere bei der Abscheidung von hochtemperatursupraleitenden Materialien auf geeignete Substrate und dabei speziell im Falle einer großflächigen Deposition erkannt, daß die Sauerstoffkonzentration im Target aus YBa₂CU₃Oₓ mit 6 < X < 7 an der Targetoberfläche stark variieren kann. Dies erscheint die Begründung für das Auftreten von inhomogenem und instabilem Abbrennen des Plasmas zu sein. Dabei spielen vor allem Änderungen des Gasstromes und das lokale Aufwärmen des Targets eine wesentliche Rolle. Es wurde erkannt, daß die Schwankungen des Sauerstoffgehaltes gezielt durch Zugabe bzw. Reduzierung des Sauerstoffanteils im Prozeßgasgemisch verhindert werden können, so daß das Plasma homogen abbrennt.

Es wurde erkannt, daß die zeitliche Änderung im Plasma durch die Beteiligung von Sauerstoff bei der Deposition von Hochtemperatursupraleitern hervorgerufen werden kann. Der Sauerstoff wird in die aus oxydischem, hochtemperatursupraleitendem Material bestehenden Schicht eingebaut (z.B. YBa₂Cu₃O₇) und ist deswegen auch im Prozeßgas vorhanden. Der Sauerstoff kann dabei auf die Oberflächen, insbesondere auch die Targetoberfläche, angelagert oder wieder von ihnen freigegeben werden. Infolgedessen wird dem Abscheidungsprozeß Sauerstoff entzogen bzw. zugeführt. Es wurde erkannt, daß vor allem der Sauerstoffgehalt der Targetoberfläche bei diesen zeitlichen Änderungen im Plasma eine wesentliche Rolle spielen. Je nach Sauerstoffgehalt zeigen einige Hochtemperatursupraleiter (HTSL) metallisches bis Isolatorverhalten.

Das erfindungsgemäße Verfahren ist nicht auf die Herstellung dünner Schichten aus hochtemperatursupraleitenden Materialien beschränkt. Vielmehr ist das erfindungsgemäße Verfahren überall dort einsetzbar, wo mit Hilfe der reaktiven Kathodenzerstäubung dünne Schichten hergestellt werden.

Im Ergebnis liefert das erfindungsgemäße Verfahren eine kontrolliertere Deposition des HTSL-Materials auf das Substrat und damit eine Verbesserung der Qualität solcher mit Hilfe der Kathodenzerstäubung hergestellten Dünnfilme.

Das erfindungsgemäße Verfahren erfaßt vorteilhafterweise sowohl eine Optimierung als auch eine verbesserte Steuerung des Depositionsprozesses. Zur Optimierung des Prozeßgasmischungsverhältnisses wird das Prozeßgas gezielt an das Plasma herangeführt, bevorzugt in der Nähe der Targetoberfläche. Dabei ist das erfindungsgemäße Verfahren keineswegs nur auf die Beschichtung kleiner Substrate, sondern in vorteilhafter Weise gerade auch bei großflächiger Beschichtung einsetzbar. Weiterhin können geeignete Profilblenden gezielt in das Targetplasma eingebracht werden.

Die erfindungsgemäße Aufgabe wird weiterhin gelöst durch eine Vorrichtung gemäß Anspruch 8. Weitere zweckmäßige oder vorteilhafte Ausführungsformen der erfindungsgemäßen Vorrichtung finden sich in den Ansprüchen 9 bis 12. Als Inertgas im Gasgemisch des Prozeßgases eignet sich z.B. Argon oder Xenon. Als reaktives Gas kann z.B. Stickstoff, Sauerstoff, Fluor oder einer der anderen reaktiven Gase der Hauptgruppe VI oder VII des periodischen Systems vorgesehen sein.

In den nachfolgenden Abbildungen sind Ergebnisse, erzielt mit dem erfindungsgemäßen Verfahren und der erfindungsgemäßen Vorrichtung dargestellt.

Es zeigen:
- Figur 1: relative, integrale, über das gesamte Querschnittsprofil gemessene Intensität der Emissionslinie bei 845 nm des atomaren Sauerstoffs als Funktion der Zeit ohne Nachsteuerung des Profils dieser Emissionslinie mit Hilfe des Prozeßgasmischungsverhältnisses;
- Figur 2: relative, integral über das gesamte Querschnittsprofil gemessene Intensität der Emissionslinie bei 845 nm des atomaren Sauerstoffs als Funktion der Zeit mit Nachsteuerung des Profils dieser Emissionslinie mit Hilfe des Prozeßgasmischungsverhältnisses;
- Figur 3: ortsaufgelöstes Querschnittsprofil zu zwei verschiedenen Zeiten während der Kathodenzerstäubung ohne stabiliserende Nachsteuerung des Profils der gewählten Emissionslinie mit Hilfe des Prozeßgasmischungsverhältnisses;
- Figur 4: ortsaufgelöstes Querschnittsprofil zu zwei verschiedenen Zeiten während der Kathodenzerstäubung mit Nachsteuerung des Profils der gewählten Emissionslinie mit Hilfe des Prozeßgasmischungsverhältnisses;
- Figur 5: Darstellung des Bereichs des Plasmas zwischen Target und Substrat.

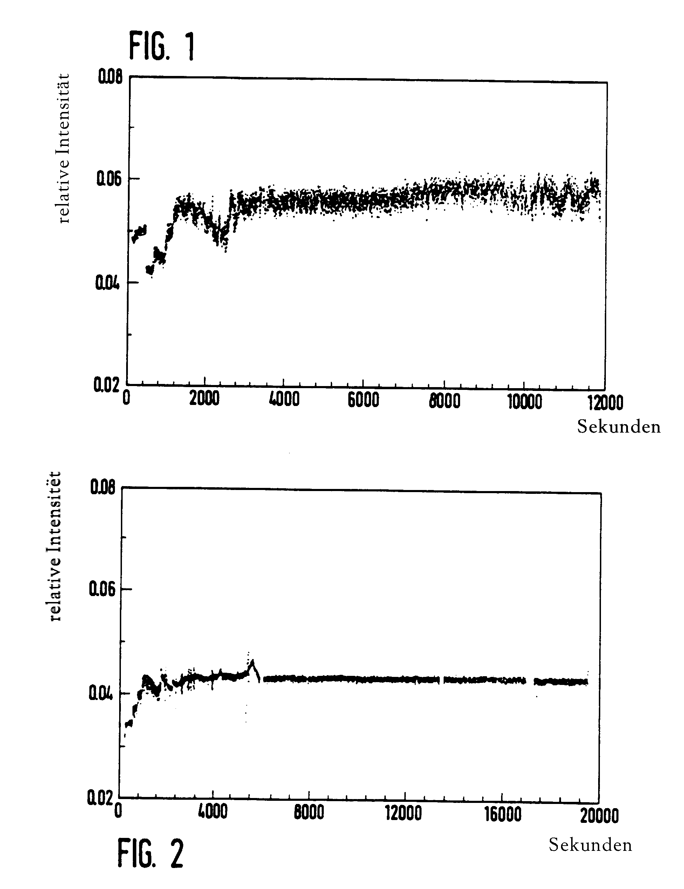

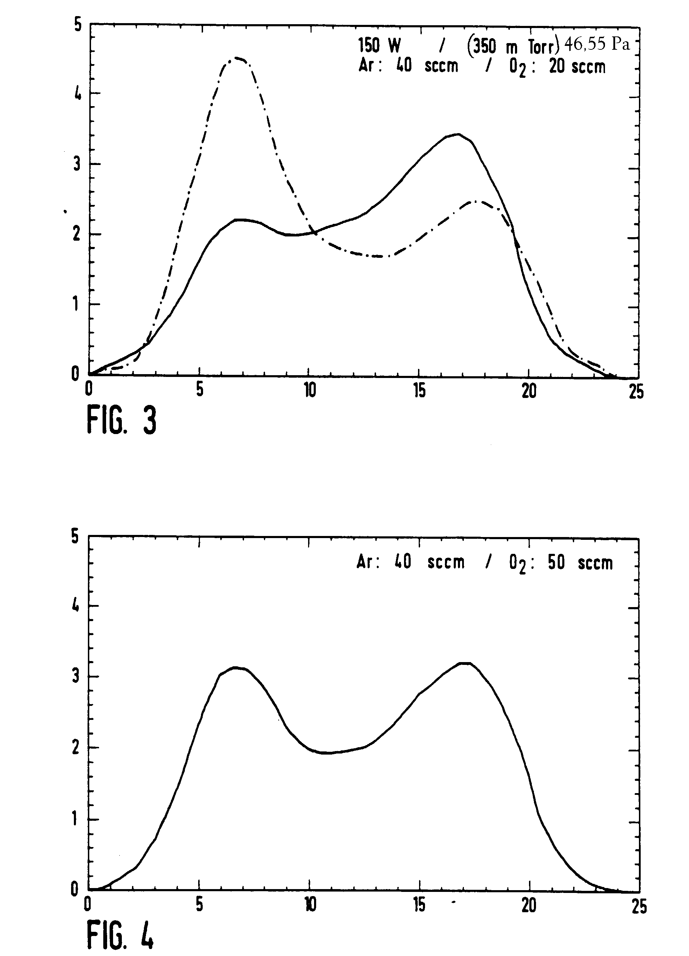

In den nachfolgenden Figuren 1 bis 5 werden Ergebnisse gezeigt zu der Herstellung eines Dünnfilmes aus hochtemperatursupraleitendem YBa₂Cu₃O₇ mit Hilfe der reaktiven Kathodenzerstäubung. Bei einem Prozeßgasdruck in der Prozeßkammer von 46,55 Pa (350 mTorr) wurde dabei ein Gasgemisch aus 40 Standard-ccm Argon und 20 Standard-ccm Sauerstoff gewählt.

In den Figuren 1 und 2 ist als Funktion der Zeit die relative Intensität der beobachteten Sauerstofflinie bei 845 nm, integral über das gesamte Querschnittsprofil gemessen, als Funktion der Zeit aufgetragen. Dabei beobachtet man in beiden Figuren den sog. Einsputtervorgang im Bereich der ersten 1000 - 2000 s.

Die Figur 1 zeigt Ergebnisse für den Fall, daß keine Nachsteuerung des Profils dieser Emissionslinie mit Hilfe des Prozeßgasmischungsverhältnisses stattgefunden hat. Es wurde deshalb ab etwa 3000 s eine Schwankung in der eingestellten Intensität oberhalb von 3000 s beobachtet. Zum einen sieht man Langzeitschwankungen z.B. im Zeitbereich von etwa 10000 - 12000 s, die im Bereich von Minuten liegen. Kurzzeitschwankungen im Bereich von Sekunden oder weniger sind die Ursache dafür, daß die Kurve z.B. im Bereich zwischen 4000 und 6000 s die dargestellte Breite zeigt. Eine Nachsteuerung des Profils der gewählten Emissionslinie mit Hilfe des Prozeßgasmischungsverhältnisses führte, wie in der Figur 2 dargestellt, im Ergebnis nach dem Einsputtervorgang zu einer erstaunlichen Verminderung der Schwankung in der relativen Intensität. In der Figur 2 zeigt sich z.B. oberhalb von 800 s eine drastische Reduzierung, sowohl der in der Figur beobachteten Langzeit - als auch der Kurzzeitschwankungen in der relativen Intensität. Im Ergebnis wurde eine weitaus bessere Dünnschichtherstellung mit der Nachsteuerung im Vergleich zu dem Fall ohne Nachsteuerung erzielt.

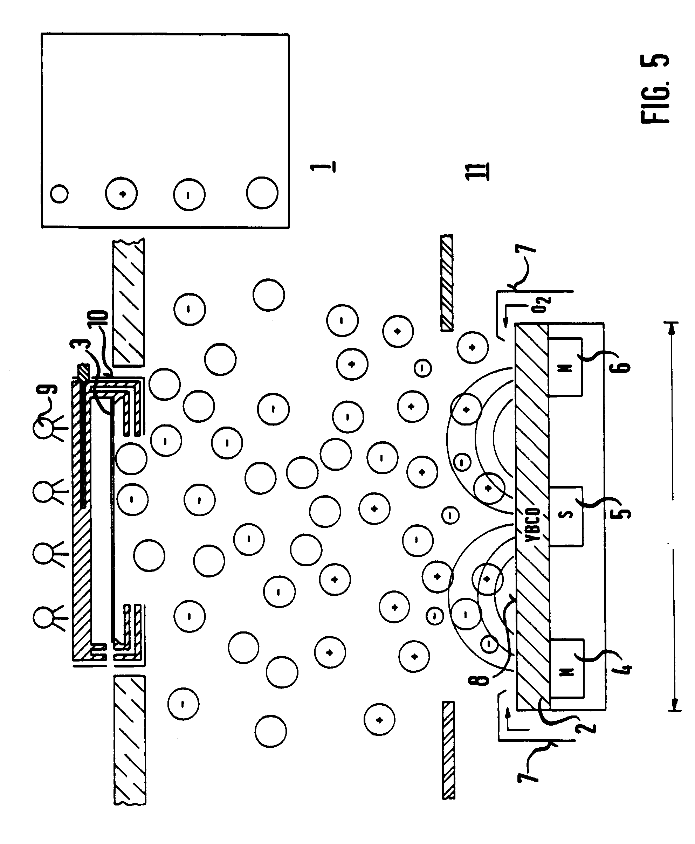

In den Figuren 3 und 4 sind die Ergebnisse zu den beiden oben geschilderten Experimenten in Bezug auf das ortsaufgelöste Querschnittsprofil angegeben.

Es zeigt sich unter den gleichen experimentellen Bedingungen wie oben angegeben, daß sich das gewünschte Querschnittsprofil während der Messung ändert. Es sind für zwei verschiedene Zeiten im Falle der fehlenden Nachsteuerung im obigen Sinne in der Figur 3 zwei Profile zu unterschiedlichen Zeiten dargestellt. Die drastischen Schwankungen in der Form des Profils verursachen eine zeitlich inhomogene Deposition des HTSL-Materials am Substrat. Durch Nachsteuerung im obigen Sinne konnte die Form des Querschnittsprofils konstant gehalten werden. Es stellte sich dann heraus, daß aufgrund dieser Maßnahme auch die kurzzeitigen Schwankungen im Plasma in vorteilhafter Weise stark reduziert wurden. Im Ergebnis lagen Dünnfilme mit verbesserten Eigenschaften vor.

In der Figur 5 ist schematisch der Bereich um das Plasma 1 zwischen dem Target 2 und dem Substrat 3 gezeigt. Als Targetmaterial ist hochtemperatursupraleitendes YBa₂CU₃Oₓ gewählt. Desweiteren ist mit Hilfe eines Magnetsystems 4, 5, 6 ein Magnetfeld an der Targetoberfläche erzeugt worden (Magnetron). Mit Hilfe des Blendensystems 7 wird gezielt Sauerstoff (O₂) an die Targetoberfläche 8 herangeführt.

Während der Kathodenzerstäubung bildet sich im Bereich zwischen Target und Substrat aufgrund der Wahl des Prozeßgasgemisches Argon/Sauerstoff das Plasma 1 aus, das dabei die Komponenten der negativ geladenen Sauerstoffatome, sowie Elektronen, positiv geladene Argonatome sowie neutrale Teilchen (z.B. Y, Ba, Cu, Oxide, Ar) enthält.

Die negativ geladenen Teilchen, insbesondere die negativ geladenen Sauerstoffatome, werden in Richtung des als Anode 10 ausgebildeten Substrats beschleunigt. Das Substrat wurde durch Strahlungsheizungen 9 auf einer definierten, erhöhten Temperatur gehalten. Zur Einschnürung des Plasma 1 ist weiterhin ein Shutter 11 vorgesehen. Als Langmuirsonde diente in diesem Falle der Substrathalter 10.

Bei Substratdurchmesser von 4 Zoll und Targetdurchmesser von 6 Zoll bildete sich bei angelegter Spannung von ca. 200 Volt zwischen Kathode und Anode ein Strom von etwa 1 A aus. Es wurde dabei eine Spannung von ca. -16 Volt an dem als Langmuirsonde ausgebildeten Substrathalter beobachtet. Die Schwankungen im Plasma führten an der Sonde zu Änderungen des Spannungswertes von bis zu einigen Volt. Diese Schwankungen wurden durch Nachregelung des Prozeßgasgemisches beseitigt (kleiner 0,1 Volt).

Mit der nachgeregelten Vorrichtung wurden 100 - 300 nm dicke YBa₂CU₃Oₓ-Schichten auf einem MgO-Substrat hergestellt. Alternativ könnte auch SrTiO₃ als Substratmaterial gewählt werden. Diese Schichten zeigten hinsichtlich der Homogenität des elektrischen Widerstandes, gemessen über die Substratoberfläche mit Schwankungen geringer als 2,5 % des mittleren Widerstandswertes, was einen extremen Wert für Hochtemperatursupraleiter bedeutet.

Im Vergleich dazu lag der Wert im Falle einer solchen Schichtherstellung ohne Nachregelung mit Hilfe der Langmuirsonde bei 25 % des mittleren Widerstandes.

## Patentansprüche

1. Verfahren zur Herstellung dünner Schichten mittels reaktiver Kathodenzerstäubung, bei dem in einer Prozeßkammer mit Gaseinlaß und Gasauslaß zwecks Steuerung eines als Gasgemisch vorhandenen Prozeßgases, wenigstens einem als Kathode vorgesehenen Target, sowie einem Substrat der Druck des Prozeßgases konstant gehalten wird, während Material vom Target abgestäubt und auf das Substrat abgeschieden wird,
**dadurch gekennzeichnet,**
daß
- das Prozeßgas in der Kammer bis an das das Target während der Kathodenzerstäubung umgebende Plasma herangeführt wird,
- eine oder mehrere Emissionslinien wenigstens einer der im Plasma vorhandenen Komponenten in einem räumlichen Bereich einer zur Targetoberfläche parallel verlaufenden Querschnittsfläche im Plasma für die Dauer der Kathodenzerstäubung in-situ profilmäßig spektroskopisch erfaßt wird und
- nach Einstellen eines gewünschten Querschnittsprofiles dieses Querschnittsprofil mittels Nachregelung des Prozeßgasmischungsverhältnisses zeitlich konstant gehalten wird.

2. Verfahren nach Anspruch 1,
**dadurch gekennzeichnet,**
daß ein symmetrisches Querschnittsprofil eingestellt wird.

3. Verfahren nach Anspruch 1 oder 2,
**dadurch gekennzeichnet,**
daß als Prozeßgas ein aus wenigstens einem Inertgas und wenigstens einem reaktiven Gas der Hauptgruppe VI oder VII, insbesondere N₂, O₂ oder F₂, zusammengesetztes Gasgemisch gewählt wird.

4. Verfahren nach einem der Ansprüche 1 bis 3,
**dadurch gekennzeichnet,**
daß als Prozeßgas eine Mischung aus Argon und Sauerstoff gewählt wird.

5. Verfahren nach einem der Ansprüche 1 bis 4,
**dadurch gekennzeichnet,**
daß der relative Gehalt des reaktiven Gases im Gasgemisch im Bereich von 5 bis zu 80 % gewählt wird.

6. Verfahren nach einem der Ansprüche 1 bis 5,
**dadurch gekennzeichnet,**
daß als Material für das Target ein oxydischer Hochtemperatursupraleiter gewählt wird.

7. Verfahren nach einem der vorherigen Ansprüche,
**dadurch gekennzeichnet,**
daß ein als Bias vorgesehenes, auf einem geeigneten elektrischen Potential gehaltenes Blendensystem im Bereich des während der Kathodenzerstäubung dem Target umgebenden Plasma so angeordnet wird, daß mit einer damit verbundenen Einschnürung des Plasmas eine erhöhte Stabilität des spektroskopisch erfaßten Querschnittsprofils erreicht wird.

8. Vorrichtung zur Herstellung dünner Schichten mit Hilfe einer zur reaktiven Kathodenzerstäubung geeigneten Kammer mit Gaseinlaß und Gasauslaß zwecks Steuerung eines als Gasgemisch vorhandenen Prozeßgases, wenigstens einem als Kathode vorgesehenen Target, sowie einem Substrat,
**dadurch gekennzeichnet,**
daß
- eine Prozeßgasführung vorgesehen ist, die das Gas in der Kammer vom Gaseinlaß bis an das das Target während der Kathodenzerstäubung umgebende Plasma heranführt,
- eine Meßeinrichtung zur in-situ Registrierung der Intensität einer oder mehreren Emissionslinien einer oder mehrerer im Plasma vorhandenen Komponenten vorgesehen ist, die so angeordnet ist, daß das Querschnittsprofil der Emissionslinie in einem räumlichen Bereich einer zur Targetoberfläche parallel verlaufenden Querschnittsfläche im Plasma erfaßt wird,
- zur Optimierung und/oder und/oder Steuerung eines erfaßten Querschnittsprofils eine Regelungseinheit vorgesehen ist, die in Abhängigkeit des Meßsignals von der spektroskopischen Meßeinrichtung die Einstellung eines gewünschten Querschnittsprofils und eine nachfolgende Nachregelung des Prozeßgasmischungsverhältnisses derart ermöglicht, daß dadurch das Querschnittsprofil zeitlich konstant gehalten werden kann.

9. Vorrichtung nach Anspruch 8,
**dadurch gekennzeichnet,**
daß Prozeßgas in der Kammer vorhanden ist und als Prozeßgas ein Gasgemisch aus wenigstens einem Inertgas und wenigstens einem reaktiven Gas der Hauptgruppe VI oder VII, insbesondere N₂, O₂ oder F₂, vorgesehen ist.

10. Vorrichtung nach Anspruch 8 oder 9,
**dadurch gekennzeichnet,**
daß Prozeßgas in der Kammer vorhanden ist und als Prozeßgas eine Mischung aus Argon und Sauerstoff vorgesehen ist.

11. Vorrichtung nach einem der Ansprüche 8 bis 10,
**dadurch gekennzeichnet,**
daß das Target oder die Targets aus einem Material bestehen, das ein oxydischer Hochtemperatursupraleiter ist.

12. Vorrichtung nach einem der Ansprüche 8 bis 11,
**dadurch gekennzeichnet,**
daß als Bias ein auf einem geeigneten elektrischen Potential gehaltenes Blendensystem zur Einschnürung des Targetplasmas vorgesehen ist.

## Claims

1. A process for producing thin films by means of reactive cathode sputtering. wherein, in a process chamber having a gas inlet and a gas outlet for the purpose of controlling a process gas present as a gas mixture, having at least one target provided as a cathode and having a substrate, the pressure of the process gas is held constant whilst material is sputtered from the target and is deposited on the substrate,
characterised in that
- the process gas in the chamber is led up to the plasma surrounding the target during cathode sputtering,
- the profile of one or more emission lines of at least one of the components present in the plasma is spectroscopically determined in situ in a spatial region of a cross-sectional expanse in the plasma which extends parallel to the target surface for the duration of the cathode sputtering, and
- after setting a desired cross-sectional profile. this cross-sectional profile is kept constant with time by means of readjusting the process gas mixture ratio.

2. A process according to claim 1,
characterised in that
a symmetrical cross-sectional profile is set.

3. A process according to claim 1 or 2,
characterised in that
a gas mixture, which is composed of at least one inert gas and at least one reactive gas of main group VI or VII, particularly N₂, O₂ or F₂, is selected as the process gas.

4. A process according to any one of claims 1 to 3,
characterised in that
a mixture of argon and oxygen is selected as the process gas.

5. A process according to any one of claims 1 to 4,
characterised in that
the relative content of the reactive gas in the gas mixture is selected within the range from 5 to 80 %.

6. A process according to any one of claims 1 to 5,
characterised in that
an oxide high-temperature superconductor is selected as the material for the target.

7. A process according to any one of the preceding claims,
characterised in that
a screen system which is provided as a bias and which is held at a suitable electrical potential is disposed in the region of the plasma which surrounds the target during cathode sputtering so that by a constriction. which is associated therewith, of the plasma an increased stability of the spectroscopically determined cross-sectional profile is achieved.

8. A device for producing thin films with the aid of a chamber which is suitable for reactive cathode sputtering and which has a gas inlet and a gas outlet for the purpose of controlling a process gas present as a gas mixture, which has at least one target provided as a cathode, and which has a substrate,
characterised in that
- a process gas guidance means is provided which leads the gas in the chamber from the gas inlet up to the plasma which surrounds the target during cathode sputtering,
- a measuring device is provided for the in-situ recordings of the intensity of one or more emission lines of one or more components present in the plasma, and is disposed so that the cross-sectional profile of the emission line is recorded in a spatial region of a cross-sectional expanse in the plasma which extends parallel to the target surface,
- a control device is provided for optimising and/or controlling a recorded cross-sectional profile, which control device makes it possible, depending oil the measured signal from the spectroscopic measuring device, to set a desired cross-sectional profile and to effect a subsequent readjustment of the process gas mixture ratio in such a way that the cross-sectional profile can thereby be held constant with respect to time.

9. A device according to claim 8,
characterised in that
a process gas is presents in the chamber and a gas mixture, which comprises at least one inert gas and at least one reactive gas of main group VI or VII, particularly N₂, O₂ F₂, is provided as the process gas.

10. A device according to claim 8 or 9,
characterised in that
a process gas is present in the chamber and a mixture of argon and oxygen is provided as the process gas.

11. A device according to any one of claims 8 to 10,
characterised in that
the target or targets consist of a material which is an oxide high-temperature superconductor.

12. A device according to any one of claims 8 to 11,
characterised in that
a screen system which is held at a suitable electrical potential is provided as a bias for the constriction of the target plasma.

## Revendications

1. Procédé pour fabriquer des couches minces par pulvérisation cathodique réactive, selon lequel dans une chambre de traitement comportant une entrée et une sortie pour le gaz en vue de réaliser la commande d'un gaz de traitement présent en tant que mélange gazeux, et comportant au moins une cible prévue en tant que cathode, ainsi qu'un substrat, la pression du gaz de traitement est maintenue constante, tandis que le matériau de la cible est pulvérisé et se dépose sur le substrat,
caractérisé en ce que
- on introduit le gaz de traitement dans la chambre jusqu'au niveau du plasma entourant la cible pendant la pulvérisation cathodique,
- on détecte in situ, par voie spectroscopique, le profil d'une ou plusieurs raies d'émission d'au moins l'un des constituants présents dans le plasma, dans une zone spatiale d'une surface en coupe transversale, qui est parallèle à la surface de la cible, dans le plasma pendant la durée de la pulvérisation cathodique, et
- après réglage d'un profil désiré en coupe transversale, on maintient ce profil en coupe transversal constant dans le temps au moyen d'une régulation par asservissement du rapport du mélange du gaz de traitement.

2. Procédé selon la revendication 1, caractérisé en ce qu'on règle un profil symétrique en coupe transversale.

3. Procédé selon la revendication 1 ou 2, caractérisé en ce qu'on choisit comme gaz de traitement un mélange gazeux constitué par au moins un gaz inerte et au moins un gaz réactif du groupe VI ou VII, notamment N₂, O₂ ou F₂.

4. Procédé selon l'une des revendications 1 à 3, caractérisé en ce qu'on choisit comme gaz de traitement un mélange d'argon et d'oxygène.

5. Procédé selon l'une des revendications 1 à 4, caractérisé en ce qu'on choisit la teneur relative du gaz réactif dans le mélange gazeux dans la gamme de 5 à 80 %.

6. Procédé selon l'une des revendications 1 à 5, caractérisé en ce qu'on choisit comme matériau pour la cible un oxyde supraconducteur à haute température.

7. Procédé selon l'une des revendications précédentes, caractérisé en ce qu'on dispose un système de diaphragmes, prévu en tant que système de polarisation et maintenu à un potentiel électrique approprié, dans la zone du plasma qui entoure la cible pendant la pulvérisation cathodique, de sorte qu'on obtient avec un étranglement, qui y est lié, du plasma une stabilité accrue du profil en coupe transversale détecté par voie spectroscopique.

8. Dispositif pour fabriquer des couches minces à l'aide d'une chambre convenant pour réaliser la pulvérisation cathodique réactive et comportant une entrée et une sortie pour le gaz, pour la commande d'un gaz de traitement présent en tant que mélange gazeux, et comportant au moins une cible prévue en tant que cathode, ainsi qu'un substrat,
caractérisé en ce que
- il est prévu un dispositif d'amenée du gaz de traitement, qui amène le gaz de traitement dans la chambre depuis l'entrée du gaz jusqu'au niveau du plasma entourant la cible pendant la pulvérisation cathodique,
- il est prévu un dispositif de mesure pour l'enregistrement in situ de l'intensité d'une ou plusieurs raies d'émission d'un ou de plusieurs constituants présents dans le plasma et qui est disposé de telle sorte que le profil en coupe transversale de la raie d'émission est détecté dans une zone spatiale d'une surface en coupe transversale, qui est parallèle à la surface de la cible, dans le plasma, et
- pour optimiser et/ou commander un profil en ccupe transversale détecté, il est prévu un dispositif de régulation qui, en fonction du signal de mesure délivré par le dispositif de mesure spectroscopique, permet le réglage d'un profil en coupe transversale désiré et une régulation ultérieure par asservissement du rapport de mélange du gaz de traitement de telle sorte que le profil en coupe transversale peut être maintenu constant dans le temps.

9. Dispositif selon la revendication 8, caractérisé en ce que le gaz de traitement est présent dans la chambre et qu'il est prévu comme gaz de traitement un mélange gazeux constitué par au moins un gaz inerte et au moins un gaz réactif du groupe principal VI ou VII, notamment N₂, O₂ ou F₂.

10. Dispositif selon la revendication 8 ou 9, caractérisé en ce que le gaz de traitement est présent dans la chambre et qu'il est prévu, en tant que gaz de traitement, un mélange d'argon et d'oxygène.

11. Dispositif selon l'une des revendications 8 à 10, caractérisé en ce que la ou les cibles sont constituées d'un matériau qui est un oxyde supraconducteur à haute température.

12. Dispositif selon l'une des revendications 8 à 11, caractérisé en ce qu'il est prévu comme système de polarisation un système de diaphragme maintenu à un potentiel électrique approprié et qui sert à étrangler le plasma de la cible.
